(19) **Europäisches Patentamt**

**European Patent Office**

**Office européen des brevets**

(11) **EP 1 316 961 B1**

(12) **EUROPEAN PATENT SPECIFICATION**

(45) Date of publication and mention
of the grant of the patent:
**26.04.2006 Bulletin 2006/17**

(51) Int Cl.:
*G11C 11/16* (2006.01)    *G11C 11/15* (2006.01)
*G11C 11/00* (2006.01)

(21) Application number: **02080284.9**

(22) Date of filing: **07.11.1997**

(54) **Ferromagnetic memory of the flip-flop type**

Ferromagnetischer Speicher vom fip-flop Typ

Mémoire ferromagnétique du type flip-flop

(84) Designated Contracting States:
**DE GB**

(30) Priority: **08.11.1996 US 30236 P**
**07.11.1997 US 965333**

(43) Date of publication of application:
**04.06.2003 Bulletin 2003/23**

(60) Divisional application:
**05077699.6**

(62) Document number(s) of the earlier application(s) in
accordance with Art. 76 EPC:
**97949382.2 / 0 937 302**

(73) Proprietor: **NVE Corporation**
**Eden Prairie, MN 55344 (US)**

(72) Inventors:
• **Daughton, James M.**
  **Eden Prairie, Minnesota 55344 (US)**
• **Everitt, Brenda A.**
  **Minneapolis, MN 55344 (US)**
• **Pohm, Arthur V.**
  **Ames, IA 50010 (US)**

(74) Representative: **Van Breda, Jacobus**
**Octrooibureau Los & Stigter B.V.,**
**Weteringschans 96**
**1017 XS Amsterdam (NL)**

(56) References cited:
WO-A-94/07244        WO-A-98/10423
US-A- 4 387 444      US-A- 4 751 677
US-A- 5 173 873      US-A- 5 448 515
US-A- 5 515 313

• **PATENT ABSTRACTS OF JAPAN vol. 1996, no.
11, 29 November 1996 (1996-11-29) -& JP 08
180672 A (MITSUBISHI ELECTRIC CORP), 12 July
1996 (1996-07-12) -& US 5 751 627 A 12 May 1998
(1998-05-12)**

**Description**

BACKGROUND OF THE INVENTION

The present invention relates to ferromagnetic thin-film structures exhibiting relatively large magnetoresistive characteristics and, more particularly, to such structures used for the storage and retrieval of digital data.

Many kinds of electronic systems make use of magnetic devices including both digital systems, such as memories, and analog systems such as magnetic field sensors. Digital data memories are used extensively in digital systems of many kinds including computer and computer systems components, and digital signal processing systems. Such memories can be advantageously based on the storage of digital symbols as alternative states of magnetization in magnetic materials provided in each memory storage cell, the result being memories which use less electrical power and do not lose information upon removals of such electrical power.

Such memory cells, and magnetic field sensors also, can often be advantageously fabricated using ferromagnetic thin-film materials, and are often based on magnetoresistive sensing of magnetic states, or magnetic conditions, therein. Such devices may be provided on a surface of a monolithic integrated circuit to provide convenient electrical interconnections between the device and the operating circuitry therefor.

Ferromagnetic thin-film memory cells, for instance, can be made very small and packed very closely together to achieve a significant density of information storage, particularly when so provided on the surface of a monolithic integrated circuit. In this situation, the magnetic environment can become quite complex with fields in any one memory cell affecting the film portions in neighboring memory cells. Also, small ferromagnetic film portions in a memory cell can lead to substantial demagnetization fields which can cause instabilities in the magnetization state desired in such a cell.

These magnetic effects between neighbors in an array of closely packed ferromagnetic thin-film memory cells can be ameliorated to a considerable extent by providing a memory cell based on an intermediate separating material having two major surfaces on each of which an anisotropic ferromagnetic memory thin-film is provided. Such an arrangement provides significant "flux closure," i.e. a more closely confined magnetic flux path, to thereby confine the magnetic field arising in the cell to affecting primarily just that cell. This result is considerably enhanced, by choosing the separating material in the ferromagnetic thin-film memory cells to each be sufficiently thin. Similar "sandwich" structures are also used in magnetic sensors.

In the recent past, reducing the thicknesses of the ferromagnetic thin-films and the intermediate layers in extended "sandwich" structures, and adding possibly alternating ones of such films and layers, i.e. superlattices, have been shown to lead to a "giant magnetoresistive effect" being present in some circumstances. This effect yields a magnetoresistive response which can be in the range of up to an order of magnitude or more greater than that due to the well known anisotropic magnetoresisdve response.

In the ordinary anisotropic magnetoresistive response, varying the difference occurring between the direction of the magnetization vector in a ferromagnetic thin-film and the direction of sensing currents passed through that film leads to varying effective electrical resistance in the film in the direction of the current. The maximum electrical resistance occurs when the magnetization vector in the field and the current direction therein are parallel to one another, while the minimum resistance occurs when they are perpendicular to one another. The total electrical resistance in such a magnetoresistive ferromagnetic film can be shown to be given by a constant value, representing the minimum resistance, plus an additional value depending on the angle between the current direction in the film and the magnetization vector therein. This additional resistance has a magnitude characteristic that follows the square of the cosine of that angle.

Operating magnetic fields imposed externally can be used to vary the angle of the magnetization vector in such a film portion with respect to the easy axis of that film. Such an axis comes about in the film because of an anisotropy therein typically resulting from depositing the film during fabrication in the presence of an external magnetic field oriented in the plane of the film along the direction desired for the easy axis in the resulting film. During subsequent operation of the device having this resulting film, such operational magnetic fields imposed externally can be used to vary the angle to such an extent as to cause switching of the film magnetization vector between two stable states which occur for the magnetization being oriented in opposite directions along the film's easy axis. The state of the magnetization vector in such a film can be measured, or sensed, by the change in resistance encountered by current directed through this film portion. This arrangement has provided the basis for a ferromagnetic, magnetoresistive anisotropic thin-film to serve as a memory cell.

In contrast to this arrangement, the resistance in the plane of a ferromagnetic thin-film is isotropic for the giant magnetoresistive effect rather than depending on the direction of the sensing current therethrough as for the anisotropic magnetoresistive effect. The giant magnetoresistive effect involves a change in the electrical resistance of the structure thought to come about from the passage of conduction electrons between the ferromagnetic layers in the "sandwich" structure, or superlattice structure, through the separating nonmagnetic layers with the resulting scattering occurring at the layer interfaces, and in the ferromagnetic layers, being dependent on the electron spins. The magnetization dependant component of the resistance in connection with this effect varies as the sine of the absolute value of half the angle between the magnetization vectors in the ferromagnetic thin-films provided on either side of an intermediate nonmagnetic layer. The electrical resistance in the giant magnetoresistance effect through the "sandwich" or superlattice structure is lower if the magnetizations in the separated ferromagnetic thin-films are parallel and oriented in the same direction than it is if these magnetizations are antiparallel, i.e. oriented in opposing or partially opposing directions. Further, the anisotropic magnetoresistive effect in very thin films is considerably reduced from the bulk values therefor in thicker films due to surface scattering, whereas a significant giant magnetoresistive effect is obtained only in very thin films. Nevertheless, the anisotropic magnetoresistive effect remains present in the films used in giant magnetoresistive effect structures.

As indicated above, the giant magnetoresistive effect can be increased by adding further alternate intermediate nonmagnetic and ferromagnetic thin-film layers to extend a "sandwich" structure into a stacked structure, i.e. a superlanice structure. The giant magnetoresistive effect is sometimes called the "spin valve effect" in view of the explanation that a larger fraction of conduction electrons are allowed to move more freely from one ferromagnetic thin-film layer to another if the magnetizations in those layers are parallel than if they are antiparallel or partially antiparallel to thereby result in the magnetization states of the layers acting as sort of a "valve."

Thus, a digital data memory cell based on the use of structures exhibiting the giant magnetoresistive effect is attractive as compared to structures based on use of an anisotropic magneto ve effect because of the larger signals obtainable in information retrieval operations with respect to such cells. Such larger magnitude signals are easier to detect without error in the presence of noise thereby leading to less critical requirements on the retrieval operation circuitry.

A memory cell structure suitable for permitting the storing and retaining of a digital bit of information, and for permitting retrieving same therefrom has been demonstrated based on a multiple layer "sandwich" construction in a rectangular solid. This cell has a pair of ferromagnetic layers of equal thickness and area separated by a conductive nonmagnetic layer of the same shape and area parallel to the ferromagnetic layers but of smaller thickness. These ferromagnetic layers are each a composite layer formed of two strata each of a different magnetic material, there being a relatively thin ferromagnetic stratum in each of the composite layers adjacent the nonmagnetic layer and a thicker ferromagnetic stratum in each of the composite layers adjacent the thin ferromagnetic stratum therein. The ferromagnetic material of the thick stratum in one of the composite layers is the same as that in the thin stratum in the other composite layer, and the ferromagnetic material of the thin stratum in the first composite layer is the same as the ferromagnetic material in the thick stratum of the second composite layer. Each of the composite layers is fabricated in the presence of a magnetic field so as to result in having an easy axis parallel to the long sides of the rectangular solid. The dimensions of the cell structure were $10\mu$m in length and $5\mu$m in width with a nonmagnetic layer of thickness 30Å. The composite ferromagnetic layers are each formed of a 15Å thin stratum and a 40Å thick stratum.

Thus, this memory cell structure has a pair of ferromagnetic layers of matching geometries but different magnetic materials in the strata therein to result in one such layer having effectively a greater saturation magnetization and a greater anisotropy field than the other to result in different coercivities in each. In addition, the structure results in a coupling of the magnetization between the two ferromagnetic layers therein due to exchange coupling between them leading to the magnetizations in each paralleling one another in the absence of any applied magnetic fields. As a result, the electrical resistance of the cell along its length versus applied magnetic fields in either direction parallel thereto is represented by two characteristics depending on the magnetization history of the cell. Each of these characteristics exhibits a peak in this resistance for applied longitudinal fields having absolute values that are somewhat greater than zero, one of these characteristics exhibiting its peak for positive applied longitudinal fields and the other characteristic exhibiting its peak for negative applied longitudinal fields. The characteristic followed by the resistance of the cell for relatively small applied longitudinal fields depends on which direction the magnetization is oriented along the easy axis for the one of the two ferromagnetic layers having the larger coercivity. Thus, by setting the magnetization of the layer with the higher coercivity, a bit of digital information can be stored and retained, and the value of that bit can be retrieved without affecting this retention through a determination of which characteristic the resistance follows for a relatively small applied longitudinal field.

Such memory cell behavior for this structure can be modeled by assuming that the ferromagnetic layers therein are each a single magnetic domain so that positioning of the magnetization vectors in the ferromagnetic layers is based on coherent rotation, and that uniaxial anisotropies characterize those layers. The angles of the magnetization vectors in the two ferromagnetic layers with respect to the easy axis in those layers are then found by minimizing the magnetic energy of these anisotropies summed with that due to the applied external fields and to exchange coupling. That total energy per unit volume is then

$$E_{Tot} = E_1 + E_2 + E_{12}$$
$$= K_{n1} \sin^2 \theta_1 - M_{s1} H \cos\left(\Psi - \theta_1\right)$$
$$+ K_{n2} \sin^2 \theta_2 - M_{s2} H \cos\left(\Psi - \theta_2\right)$$
$$+ A_{12} \cos\left(\theta_1 - \theta_2\right).$$

Here, $K_{n1}$ and $K_{n2}$ are anisotropy constants, $A_{12}$ is the exchange constant, $M_{s1}$, and $M_{s2}$ are the magnetization saturation values, and H is the externally applied field. As indicated above, once the magnetization vectors have taken an angular position with respect to the easy axis of the corresponding layer at a minimum in the above indicated energy, the effective resistance between the ends of the memory cell structure is determined by the net angle between the magnetization vectors in each of these layers.

Because of the assumption of single domain behavior in the ferromagnetic layers, the above equation would seemingly be expected to improve its approximation of the assistant total magnetic energy as the length and width of that memory cell structure decreased toward having submicron dimensions. However, this mode of operation described for providing the two magnetoresistive characteristics based on the history of the layer magnetizations, in depending on the differing anisotropy fields in the two ferromagnetic layers because of the differing materials used therein, becomes less and less reliable as these dimensions decrease. This appears to occur because decreasing the cell dimensions gives rise to larger and larger demagnetizing fields in the two ferromagnetic layers which, at some point, overwhelm the effects of the anisotropy fields so that the above described behavior no longer occurs as described. In addition, the magnetizations of the two ferromagnetic layers rotate together under the influences of externally applied fields at angles with respect to the corresponding easy axis at angular magnitudes much more nearly equal to one another because of the increasing demagnetization fields in these layers as the dimensions thereof decrease. As a result, these ferromagnetic layers are less and less able to have the magnetizations thereof switch directions of orientation independently of one another as the dimensions thereof decrease so that the structure they are in becomes less able to provide the above described memory function in relying on only these ferromagnetic layer anisotropy differences.

An alternative memory cell structure which is more suited to submicron dimensions is a cell of the kind described above exhibiting "giant magnetoresistive effect" but which has the two composite ferromagnetic layers formed of different thicknesses in the thick strata therein. Thus, the thick strata in one might be on the order of 40Å while that of the other might be on the order of 55Å as an example. In this structure, reducing the size to submicron dimensions uses the shape anisotropy introduced by this thickness difference to provide different switching thresholds for each of the ferromagnetic composite layers in response to externally applied operating magnetic fields. The shape anisotropy leads to the effect of the demagnetizing field of one layer affecting the switching threshold of the other after the former layer has switched its magnetization direction. As a result, the thicker ferromagnetic layer has a magnetization which is fixed in orientation for externally applied operating magnetic fields that are just sufficient to switch the thinner ferromagnetic composite layer but not great enough to switch the magnetization of the thicker ferromagnetic composite layer. In effect, the demagnetizing fields as the device becomes sufficiently small dominate the anisotropy fields that result from the deposition of the ferromagnetic layers in the presence of a magnetic field.

In the absence of externally applied operating magnetic field, the two composite ferromagnetic layers have the magnetizations therein pointing in opposite directions. i.e. they are antiparallel to one another, to result in the structure as a whole having relatively small cell demagnetizing fields and small external stray fields to affect the nearby memory cells. The direction of magnetization in the thicker ferromagnetic composite layer is used to store the digital information which can only be changed in direction by externally applied fields great enough to switch magnetization directions in both composite ferromagnetic layers. That is, storing new information in the cell requires that the thicker ferromagnetic layer be capable of having the magnetization direction therein switched to be in accord with the incoming digital data.

Retrieving information from such a memory cell is accomplished by switching the magnetization direction of the thinner ferromagnetic composite layer only as a basis for determining in which direction relative to the thinner layer is the magnetization oriented in the thicker layer. Typically, both such storing and retrieving has meant that there needs to be a pair of external conductors which can coincidentally supply current to result in a field large enough to switch the magnetization of the thicker ferromagnetic composite layer, but with that current in either conductor alone being able to generate fields only sufficient to switch the threshold of the thinner ferromagnetic layer. In some situations, only a single external conductor need be provided for this purpose because the sense current used in retrieving information from the memory cell can provide the coincident current needed with the current in the external conductor to switch the magnetization direction of the thicker ferromagnetic layer. Such a memory cell is described in an earlier filed co-pending application by A. Pohm and B. Everitt entitled "Giant Magnetoresistive Effect Memory Cell" having Serial No. 08/923,479 assigned to the same assignee as the present application.

Such a cell formed in a "sandwich" structure would typically exhibit an output signal which is on the order of a 5% to 6% change in resistance from the nominal resistance of the cell. The retrieval of data from such a cell typically requires the use of "autozeroing" circuitry which, operated prior to the retrieving step, eliminates retrieval circuit imbalances. This need coupled with the relatively large currents used in this latter kind of memory cell results in slowing the operation of that cell, and such currents also lead to substantial power dissipation. Thus, there is a desire for an alternative arrangement for such a "sandwich" structure having submicron dimensions which provide desirable magnetoresistance versus applied magnetic field characteristics that can be used for storing and retrieving bits of digital data information but which provides a larger signal with less power dissipation so that such retrievals can be done at a greater rate without undue beat generation.

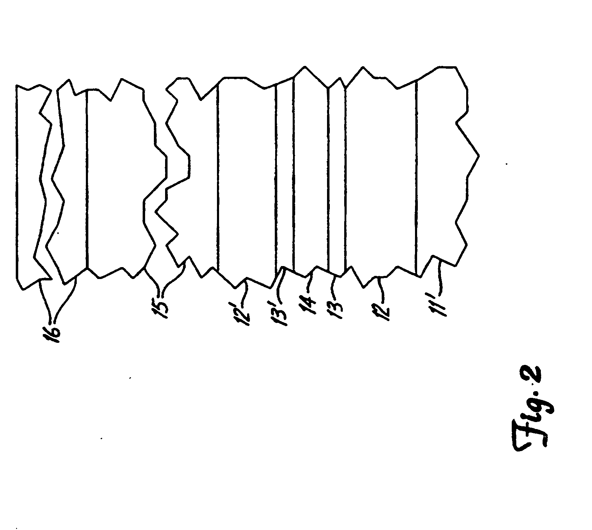

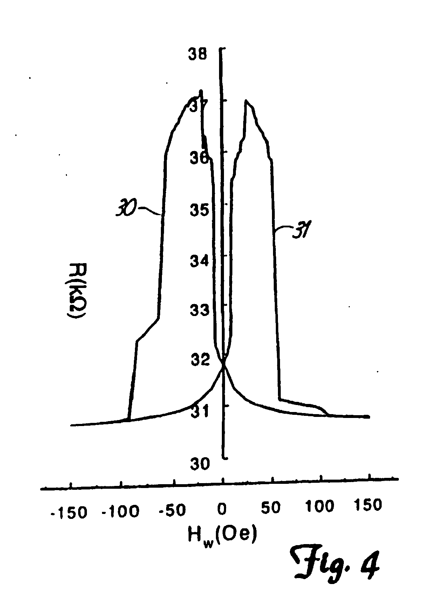

US-A-4 751 677 describes a ferromagnetic memory cell (fig.4) of the flip-flop type with a pair of ferromagnetic bit structures (7,8) as load devices, with a pair of transistors as switching devices (42',43') and with a word line (20 in fig.2) above both ferromagnetic bit structures.

## SUMMARY OF THE INVENTION

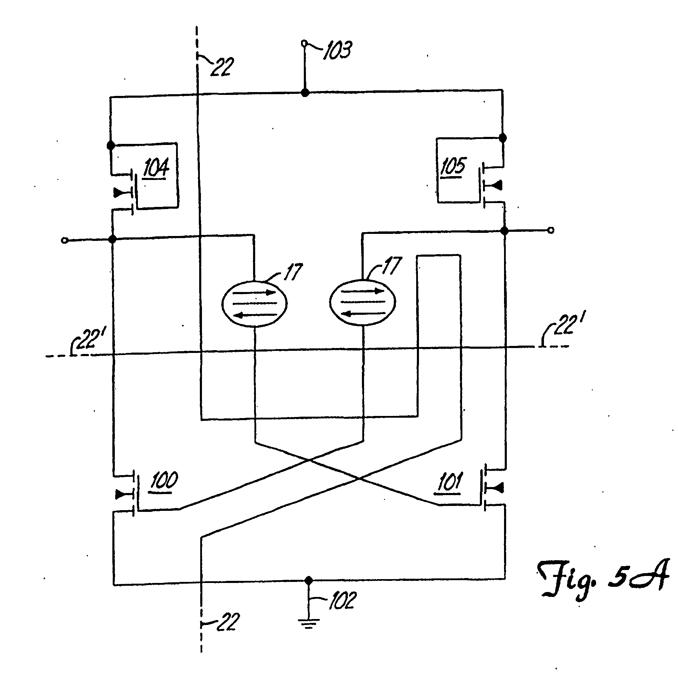

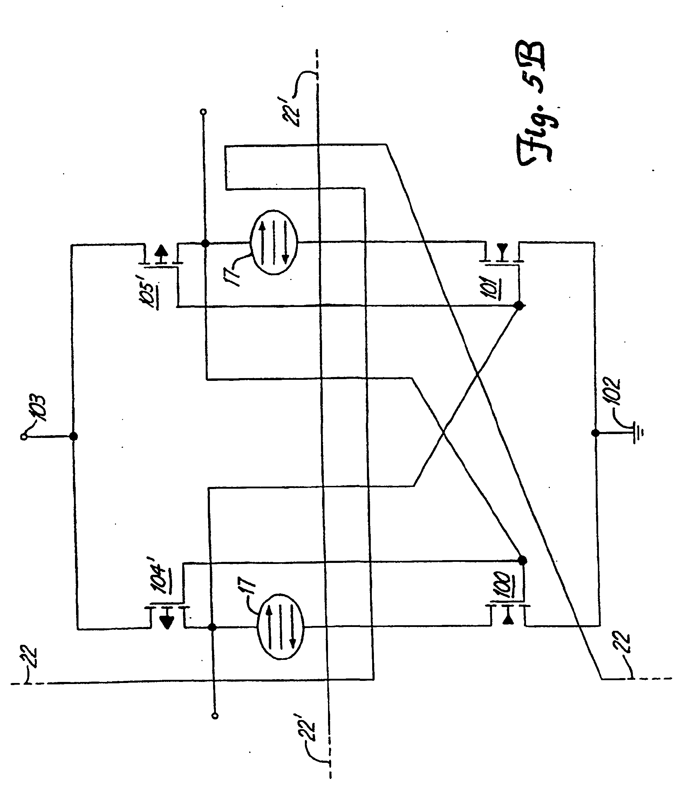

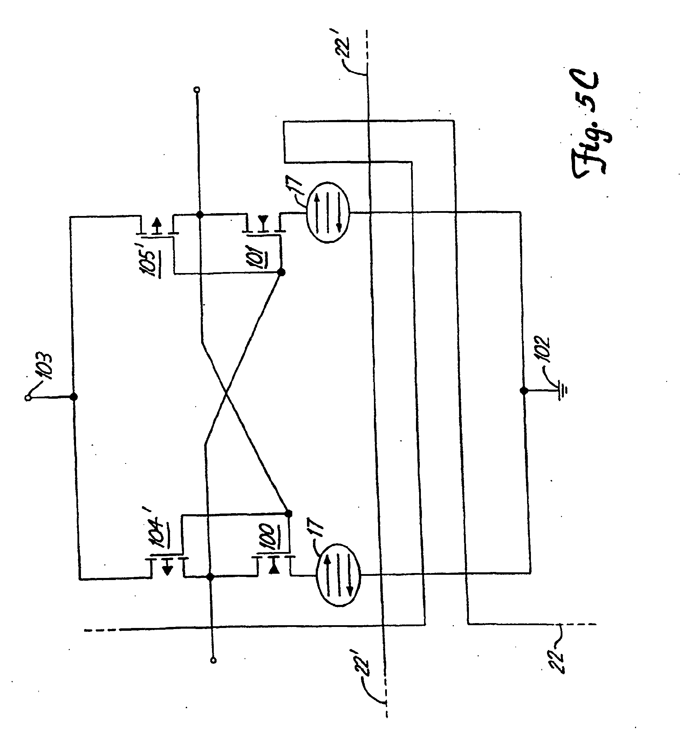

Small memories which are embedded in other circuitry being used therewith often require larger output signals than are provided by memory cells or bit structures 17 directly. Such cells can be incorporated in a flip-flop arrangement to provide the current steering necessary to place the flip-flop in a selected state. Two such flip-flop circuits are shown in Figures 5A and 5B.

The present invention provides a ferromagnetic memory as indicated in claim 1.

## BRIEF DESCRIPTION OF THE DRAWINGS

Figures 1A and 1B represent a plan view of a portion of a monolithic integrated circuit structure embodying the present invention and a layer diagram of a part of this structure,
Figure 2 represents a fragmentary portion of the layer diagram of Figure 1B,
Figures 3A and 3B represent a plan view of a portion of a monolithic integrated circuit structure embodying an alternative to the invention and the layer diagram of a part of this structure shown in Figures 1A and 1B,
Figure 4 represents a characteristic diagram for structures similar to one of those shown in Figures 1A, 1B and 2.
Figures 5A, 5B and 5C are circuit schematic diagrams of a portion of alternative digital memory systems based on the structure shown in Figures 1A, 1B and 2.

## DETAILED DESCRIPTION OF THE PREFERRED EMBODIMENTS

A digital data bit storage and retrieval memory cell suited for fabrication with submicron dimensions can be fabricated that provides rapid retrievals of bit data stored therein and low power dissipation by substituting an electrical insulator for a conductor in the nonmagnetic layer. This memory cell can be fabricated using ferromagnetic thin-film materials of similar or different kinds in each of the magnetic memory films used in a "sandwich" structure on either side of an intermediate nonmagnetic layer which ferromagnetic films may be composite films, but this intermediate nonmagnetic layer conducts electrical current therethrough based primarily on a quantum electrodynamic effect "tunneling" current.

This "tunneling" current has a magnitude dependence on the angle between the magnetization vectors in each of the ferromagnetic layers on either side of the intermediate layer due to the transmission barrier provided by this intermediate layer depending on the degree of matching of the spin polarizations of the electrons tunneling therethrough with the spin polarizations of the conduction electrons in the ferromagnetic layers which are set by their magnetization directions to provide a "magnetic valve effect". Such an effect results in an effective resistance or conductance characterizing this intermediate layer with respect to the "tunneling" current therethrough. In addition, shape anisotropy is used in such a cell to provide different magnetization switching thresholds in the two ferromagnetic layers by forming one of the ferromagnetic layers to be thicker than the other. Such devices may be provided on a surface of a monolithic integrated circuit to thereby allow providing convenient electrical connections between each such memory cell device and the operating circuitry therefor.

A "sandwich" structure for such a memory cell, based on having an intermediate thin layer of a nonmagnetic, dielectric separating material with two major surfaces on each of which a anisotropic ferromagnetic thin-film is positioned, exhibits the "magnetic valve effect" if the materials for the ferromagnetic thin-films and the intermediate layers are properly selected and have sufficiently small thicknesses. The resulting "magnetic valve effect" can yield a response which can be several times in magnitude greater than that due to the "giant magnetoresistive effect" in a similar sized cell structure.

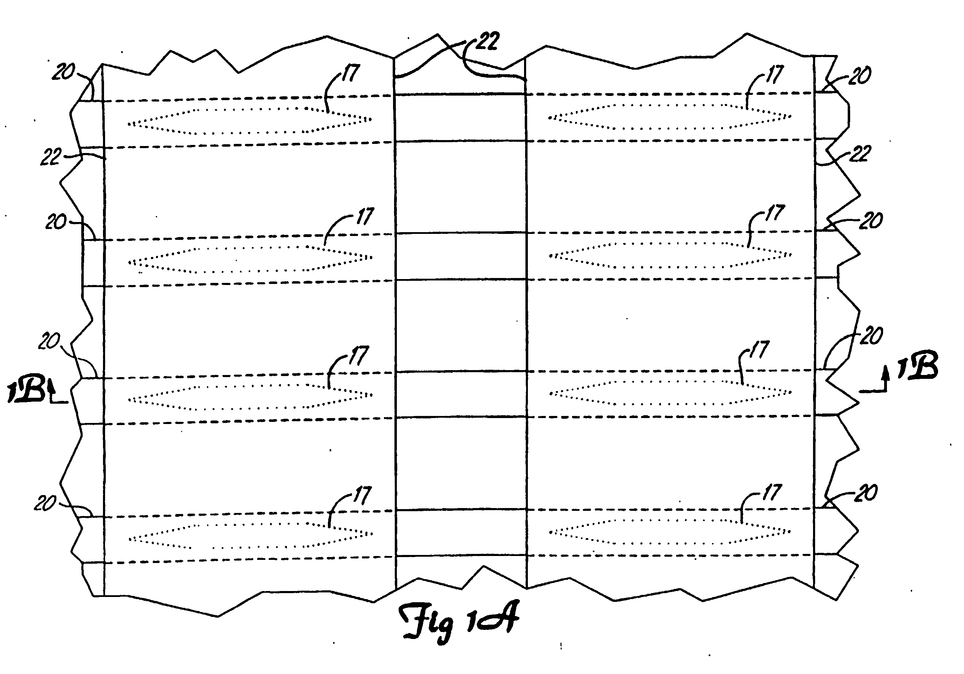

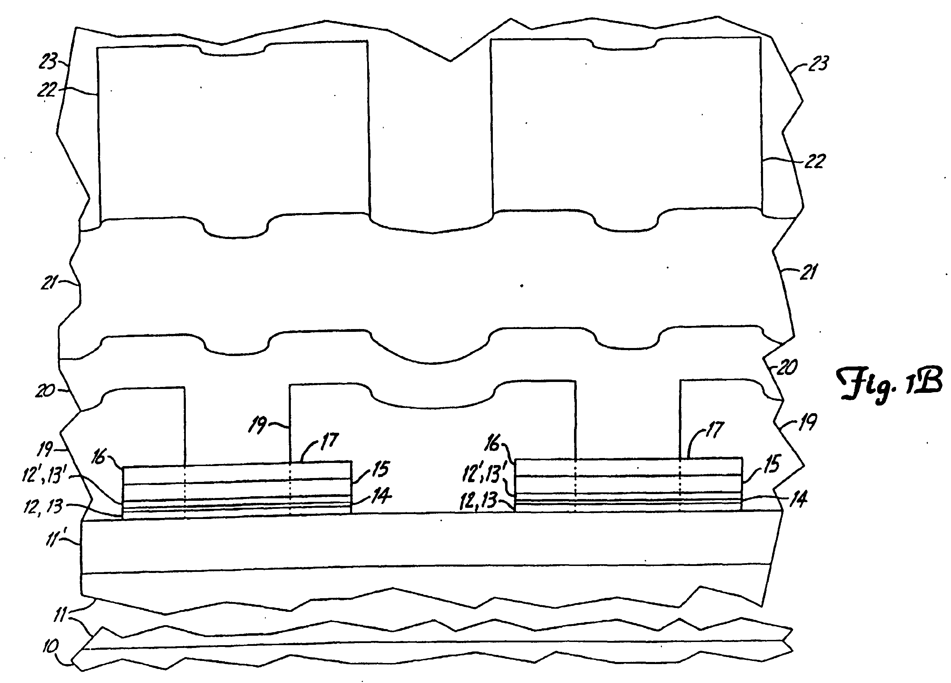

Figure 1A shows a plan view of an example of such memory cells as part of a digital memory formed as a portion of a monolithic integrated circuit, including a supporting semiconductor chip as part of the memory substrate, which can have conveniently provided therein the operating circuitry for this memory. Figure 1B provides a fragmentary view of a portion of the view shown in Figure 1A to show the layered structure thereof, and also has parts thereof broken out to show some of the structure therebelow, again for greater clarity. The protective layer provided over portions of the structure shown in Figure 1A in actual use has been omitted in this view for clarity, but that layer is shown in part in Figure 1B. Certain other portions of some layers have been omitted, again for clarity, so that the structure portions present are shown in solid line form if they are exposed in the absence of some layer thereover now omitted, but with other structure portions beneath the solid line form portions appearing in these figures being shown in dashed line form.

Corresponding to Figures 1A and 1B is Figure 2 which is a layer diagram of a corresponding portion of the structures shown in Figures 1A and 1B. this layer diagram gives an indication of the structural layers leading to portions of the structures shown in Figures 1A and 1B. but Figures 1B and 2 are not true cross section views in that many dimensions therein are exaggerated or reduced for purposes of clarity.

As indicated above, the memory cell structures in these figures are typically provided on a semiconductor chip, 10, having suitable operating circuitry for the memory provided in the resulting monolithic integrated circuit structure. An electrical insulating layer, 11, formed on semiconductor chip 10 by a sputter deposition of silicon nitride, supports the memory cell "sandwich" structures thereon each of which comprises a pair of ferromagnetic thin-film layers that are separated from one another by a nonmagnetic, electrically nonconductive or dielectric intermediate layer, or barrier layer, as will be described in more detail below. A portion of just layer 11 is shown in the high resolution drawing of Figure 2 Typically, layer 11 is formed by this silicon nitride deposited to a thickness of about 10,000Å. Photoresist is spread over layer 11 and patterned to provide via openings therethrough and through appropriate ones of the insulating layers in integrated circuit 10.

A first interconnection, 11', for the above indicated memory cell "sandwich" structures is next provided on insulating layer 11 as both this interconnection and as a further substrate portion for supporting the memory cell "sandwich" structures to be subsequently provided. Thus, a metal deposition is made on layer 11 of aluminum alloyed with 2% copper to cover that layer and fill the via openings therein for electrical interconnections to the integrated circuitry in and on the semiconductor substrate below. This metal layer is typically deposited to a thickness of 1000 Å. Photoresist is then spread thereover with openings therein where the unwanted portions of that metal layer are to be eliminated, and reactive ion etching is undertaken to provide this elimination of unwanted metal layer portions. Interconnection and support structure 11' resulting from this elimination is shown in Figures 1B and 2.

Thereafter, the "sandwich" structures just mentioned are provided on interconnection support layer 11' with each of the ferromagnetic thin-film layers and the intermediate layer being provided, or at least initially provided, through sputter deposition as a basis for forming a magnetoresistive memory cell. This multilayer structure will have a vertical direction effective resistivity based on the quantum electrodynamic effect tunneling current passing therethrough which might range from 0.01 to 10,000 M$\Omega$-$\mu$m$^2$ because of the extreme sensitivity of this effective resistivity to the thickness of the barrier layer. In addition, the structure will typically exhibit an effective capacitance and a magnetically controlled tunneling effect response exceeding 20% between the minimum effective resistance value and the maximum effective resistance value achievable under such control.

In this structure, the first layer provided is a composite ferromagnetic thin-film layer sputter deposited onto interconnection and support 11' with the result shown in Figure 2. A first stratum, 12, of this composite ferromagnetic thin-film layer is formed of an alloy of 65% nickel, 15% iron and 20% cobalt deposited to a thickness of 40Å, which has a magnetic saturation induction of typically about 10,000 Gauss, and this process results in the deposited film having a face-centered cubic structure. The deposition of this layer occurs in the presence of an external magnetic field in the plane of the film oriented along a direction parallel to the extended direction of interconnection and support 11' in Figure 1B This fabrication magnetic field will leave the easy axis of the film similarly directed. Alternatively, the deposition field may be provided at an angle to the extended direction of interconnection and support 11' to provide a bias rotation of the layer magnetization to facilitate switching the direction of that magnetization.

A second stratum, 13, is also provided in a sputter deposition step in the presence of a similar fabrication magnetic field. Second stratum 13 is formed of 5% iron and 95% cobalt to a thickness of 15Å resulting in this material having a magnetic saturation induction of approximately 16,000 Gauss which is a higher value than that of the magnetic saturation induction of first stratum 12. This higher saturation material is provided adjacent the intermediate or barrier layer, which is the next layer to be formed, to thereby obtain a greater magnetically controlled tunneling effect, but the lower saturation value in stratum 12 is provided to keep the composite film more sensitive to smaller fields than it would be in its absence. This composite layer is designated 12, 13 in Figure 1B.

Thereafter, an intermediate or barrier layer, 14, is provided by sputter deposition and oxidation onto layer 13, this intermediate layer being a dielectric. Layer 14 is begun typically by sputter depositing 12Å of aluminum onto layer 13, and continuing to provide two further angstroms of this material using the aluminum sputtering target but also introducing oxygen into the sputtering chamber. The result is to convert the already deposited aluminum layer substantially into aluminum oxide which expands its thickness by a factor of about 1.3, and to add another two angstroms of aluminum oxide thereto giving an intermediate layer or barrier layer thickness of approximately 17.5Å with the layer being formed primarily of aluminum oxide. Any portion of the previously deposited aluminum metal unoxidized in this process will result in a very thin layer of that aluminum on and between ferromagnetic layer 12,13 and the aluminum oxide dielectric barrier layer which can be advantageous.

The provision of layer 14 is followed by providing a second composite ferromagnetic thin-film layer that is provided on layer 14, and its structure matches that of the first composite ferromagnetic layer comprising strata 12 and 13, except for being thinner and reversed in strata order, because of the use of essentially the same deposition steps. As a result, the stratum having the greater magnetic saturation induction is again adjacent to layer 14 in the second composite layer, and the lesser magnetic saturation induction stratum is provided thereon but with a thickness of only 25Å. Since the strata are otherwise the same, they have been designated in Figure 2 as 13' and 12' in correspondence to strata 13 and 12.

After completing this "sandwich" structure, a 2000Å layer of tantalum or tantalum nitride is sputter deposited on stratum 12' to passivate to protect stratum 12' therebelow, and to allow electrical connections thereto for circuit purposes. The resulting layer, 15, is shown in broken form in Figure 2 because of its significantly greater thickness compared to the ferromagnetic composite layers and the nonmagnetic intermediate or barrier layer.

Similarly, a further layer, 16, is deposited on layer 15, and is shown in broken from in Figure 2 because of its relatively greater thickness of 100Å. Layer 15 is first sputter cleaned which removes around 75Å thereof. Then, layer 16 is sputter deposited on cleaned layer 15 as a chrome silicon layer with 40% chrome and 60% silicon to serve as an etch stop for the subsequent etching of a layer to be provided thereover as a milling mask.

That is, another layer of silicon nitride is next sputter deposited on layer 16 to a depth of 1000Å to be used as a milling mask, but this layer is not shown in Figure 2 because its remnants will be incorporated in a further insulating layer to be provided later. On this silicon nitride mask layer, photoresist is deposited and patterned in such a way as to form a pattern for an etching mask which is to be formed following that pattern by leaving the mask portions of the silicon nitride layer therebelow after etching. This last masking pattern in the silicon nitride is to result, after milling therethrough to remove the exposed ferromagnetic and nonmagnetic layers therebelow, in a substantial number of separated bit structures to serve as the memory cells in the digital memory each with a "sandwich" construction. Reactive ion etching is used with the patterned photoresist to remove the exposed portions of the silicon nitride masking layer down to chrome silicon layer 16 serving as an etch stop. The remaining portions of the silicon nitride layer protected by the photoresist serve as the above mentioned milling mask for the subsequent ion milling step which removes the exposed portions of chrome silicon layer 16, and thereafter, also the then exposed portions of layer 15, the next exposed portions of the second composite ferromagnetic thin-film layer formed as strata 13' and 12', the subsequently exposed portions of intermediate nonmagnetic layer 14' and, finally, the resultingly exposed portions of the first composite ferromagnetic thin-film layer formed as strata 13 and 12 down to interconnection and support 11'.

A portion of one of the resulting memory cells, 17. from Figure 1A is shown in Figure 2, as indicated above, and has counterparts thereof shown in Figure 1B (where they are designated again by numeral 17) with only some of the layers in each such cell being represented as distinct in this latter figure. The full multilayer structure that is shown in Figure 2 with the distinct strata in the composite ferromagnetic layers is not shown in that manner in Figure 1B because of the larger scale used in that figure. Some of these memory cells can also be seen in the plan view of Figure 1A, and each of such structures is also designated by numeral 17 in that figure. The easy axes of the ferromagnetic thin-film composite layers in each of memory cells 17 are parallel to the direction of the longest extent of those structures. Each memory cell 17 is formed with a rectangular central portion in this plan view continuing into triangular portions tapering away from opposite ends of the rectangular portion along the easy axis to form the ends of the cell.

Following the completion of memory cell or bit structure 17, another layer of silicon nitride is sputter deposited over those structures and the exposed portions of interconnection and support 11' to a thickness of 7500Å to form an insulating layer, 19. Photoresist is provided over insulating layer 19 as an etching mask to provide via openings therethrough, and through silicon nitride layer 11 and appropriates ones of insulating layers in integrated circuit 10.

On insulating layer 19, so prepared, a further metal deposition is made, again of aluminum alloyed with 2% copper, to cover that layer and fill the via openings therein, and in silicon nitride layer 11 and the insulating layers in integrated circuit 10. This metal layer is typically deposited to a thickness of 1000Å. Photoresist is spread thereover with openings therein where the unwanted portions of that metal layer are to be eliminated, and reactive ion etching is undertaken to provide this elimination of unwanted metal layer portions. The structures that result from this elimination is shown in Figure 1B. and in Figure 1A, as a plurality of upper interconnections, 20, for interconnecting memory cell structure 17 in parallel to one another in conjunction with interconnection and support 11'. As a result of the via openings in silicon nitride layer 11, upper interconnections 20 are also interconnected with electronic circuitry in the integrated circuits in semiconductor substrate 10 therebelow.

The completion of upper interconnection structures 20 is followed by depositing another layer of typically 7500Å of silicon nitride thereover, and over the exposed portions of silicon nitride layer 20 to form a further insulating layer, 21. Photoresist is provided over insulating layer 21 as an etching mask to provide via openings therethrough, and through silicon nitride insulating layers 19 and 11 as well as though appropriate ones of the insulating layers in integrated circuit 10.

On insulating layer 21, prepared in this manner, a further metal deposition is made, again of aluminum alloyed with 2% copper, to cover that layer and fill the openings therein, and in silicon nitride layers 19 and 11 as well as the insulating layers in integrated circuit 10. This metal layer is typically deposited to a thickness of 3500Å. Photoresist is spread thereover with openings therein where the unwanted portions of that metal layer are to be eliminated, and reactive ion etching is undertaken to provide this elimination of unwanted metal layer portions. The structures that result from this elimination are shown in Figure 1B, and in Figure 1A, as a plurality of word lines, 22, for the memory each positioned across insulating layer 21, upper interconnection structures 20. and insulating layer 19 from corresponding memory cell structures 17 supported on and interconnected to interconnections and supports 11'. As a result of the via openings, these word lines are also interconnected with electronic circuitry in the integrated circuits in semiconductor substrate 10 therebelow. A further insulator layer, 23, is provided by sputter depositing 7500Å of silicon nitride over word lines 22 and the exposed portions of insulator 21. Insulator 23 serves as a passivation and protection layer for the device structure therebelow. Layer 23 is seen in Figure 1B but is not shown in Figure 1A to avoid obscuring that figure.

A memory cell or bit structure 17 of the structure described resulting from the just described process for fabricating same will have a relatively linear change in the quantum electrodynamic effect "tunneling" current therethrough from one ferromagnetic layer to the other with respect to the voltage provided across the cell, i.e. between these ferromagnetic layers, for relatively lower voltages but the current magnitude increases more than linearly for higher values of voltage across the cell. As the voltage across the cell increases, the fractional change in the in the "tunneling" current through the cell, for the ferromagnetic layers having magnetizations changing from parallel to one another to antiparallel, decreases to being only half as great with several hundred millivolts across the cell as occurs in the situation with a hundred or less millivolts across the cell so that this fractional change with cell voltage will range from a few percent to 20% or more. The fractional change in the resistance of the cell for the ferromagnetic layers having magnetizations changing from parallel to one another to antiparallel increases to about one and one-half the room temperature values when the cell is cooled to 77° K, but the "tunneling" current through the cell increases by only about 10% to 20% indicating that the effective resistivity of the cell is relatively insensitive to temperature (around 500 to 1000 ppm/°C).

The effective resistivity of a cell 17 is set by the amount of "tunneling" current through the cell permitted by barrier layer 14 for the voltage across the cell. The high sensitivity of the "tunneling" current to the thickness of the barrier layer leads to a wide range of cell resistivities which have been observed to be from 0.01 to 1000 MΩ - $\mu m^2$. On the other hand, barrier layer 14 appears to permit relatively little magnetic coupling between the ferromagnetic layers thereacross with the coupling fields typically being only a few Oe.

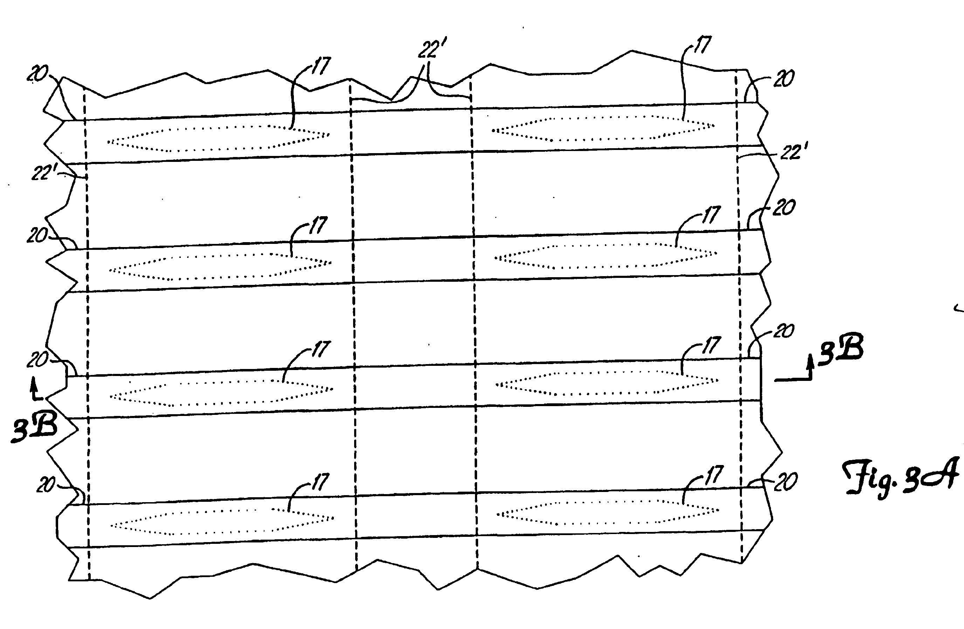

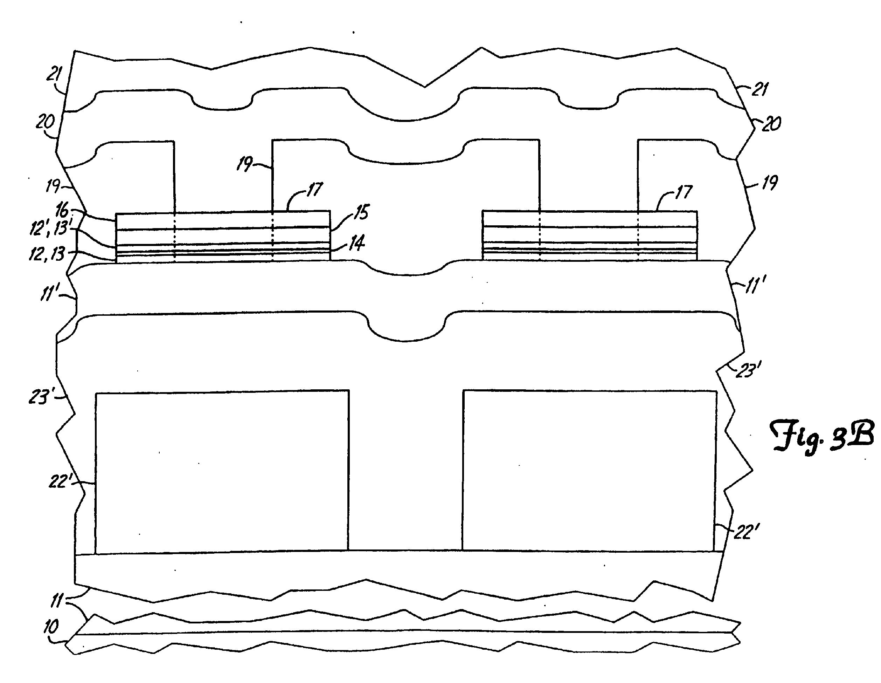

One structural arrangement alternative to that shown in Figure 1 that is possible is shown in Figures 3A and 3B. In this alternative, the word lines, now designated 22', are deposited directly on silicon nitride layer 11 with an insulating layer, now designated 23', deposited thereover to provide the supporting substrate for interconnection and support 11' and memory cells 17. Memory cells 17 are again connected parallel using interconnection and support 11' on the lower side thereof and upper interconnection 20 on the upper side thereof to provide the interconnections with memory cells 17 if connected in parallel therebetween. Insulating layer 21 now becomes the protective and passivating layer for the device. A further alternative, not shown, would be to provide word lines above and below memory cells or bit structures 17 at some angle with respect to each other, typically at right angles, for providing magnetic fields to affect the corresponding cell provided between each crossover of such word lines so that current for this purpose need not be carried in interconnection and support 11'.

The fabrication steps just described are, of course, applied to semiconductor material wafers having many integrated circuit chips therein to serve as memory substrates so that many such digital memories can be fabricated simultaneously in and on such wafers. Once all memory cell structures 17 are fabricated on each chip substrate, along with all of the associated interconnection structures and word line structures as protected by the final insulating layer, the wafers are then ready for wafer testing, for the separating of the individual devices into separate chips, and the housing of them in "packages".

The plan view of the shapes of bit structures 17, i.e. having a rectangular center portion tapering into triangular end portions at opposite ends thereof, are not the only plan view geometrical shapes which can be used. An alternative would be to form memory cell structure 17 with a plan view geometry following a parallelogram. There may be other alternative plan view shapes for memory cell structures 17 which can improve the packing density of those structures on an integrated circuit chip substrate.

A representation of a pair of typical magnetoresistance characteristics of a memory cell or bit structure 17 versus external magnetic fields applied along its length, i.e. along its easy axis, is shown in Figure 4 for an individual bit structure example of relatively larger size rather than a smaller structure taken from a parallel string thereof as a more easily understood example. A fixed quantum effect tunneling a current of 2.0μA is used as the operating current through the device between the upper interconnection and the lower interconnection to that device. This known current, along with the measured voltage across the cell, provides the resistance of that cell.

The characteristic, 30, having the peak on the left in figure 4 develops from initially having a sufficiently large magnetic field parallel to the easy axis (shown as a positive field on the plot) applied via current in the adjacent word line 22 and via interconnection and support 11' to force the magnetizations of each of the ferromagnetic thin-films 12, 13 and 13', 12' in the memory cell or bit structure 17 to be oriented in the direction of the field. These magnetizations will thus be parallel to one another pointing in an initial common direction to thereby leave the electrical resistance of the cell at a minimum (here, approximately 31 k$\Omega$).

This initial condition is followed by continually reducing this field toward zero and then reversing the field direction, after which the magnitude of the field is continually increased (shown as a negative field on the plot). As can be seen in the plot, this action begins to increase the resistance of the cell as the magnetization of thinner layer 13', 12' begins to rotate toward the opposite direction to a greater degree than does the magnetization of thicker layer 12,13. This difference occurs because of the shape anisotropy which, as structure 17 becomes sufficiently small, dominates the material anisotropy induced by deposition of the ferromagnetic layers thereof in a magnetic field or by layer material choice or both.

As a result, these begin to be directed more and more away from one another as the field gets increasingly negative, thereby increasing the cell resistance, until the magnetization of the thinner layer is rotated just past 90° from the easy axis, whereupon it abruptly switches (at approximately -10 Oe) to being significantly directed in the opposite direction from that of the thicker layer as it attempts to align with the fields provided by the word line and interconnection line currents. At that point, the resistance value correspondingly increases abruptly to the peak value shown of approximately 37 k$\Omega$. The switching field threshold value is set by the bit width and the net magnetic moment of the ferromagnetic layer which in turn is set by magnitude of the saturation magnetization and the volume of that layer. Since the volume, and so the moment, can be chosen by selecting a suitable and different layer thickness with respect to that of the other layer to provide shape anisotropy, these ferromagnetic layers, even if otherwise identical, can have different switching threshold values.

As memory cells 17 are fabricated sufficiently small to be considered as having the composite layer ferromagnetic thin-films used therein to be single magnetic domain structures, the critical magnetic field magnitude (-10Oe), or threshold, for the thinner layer at which such switching occurs (a threshold found much like the well known Stoner Wohlfarth threshold which is defined for larger area films not subject to exchange coupling and edge effects) is determined from layer magnetic energy considerations including the magnitude of the magnetic fields established by the interconnection structure current in addition to that established by the word line current. (The field due to the operating current across the intermediate layer can be neglected because this current is so relatively small). Further magnitude increases in the negative field do not, however, cause the magnetization of the thicker layer to switch to being directed in the opposite direction at the expected Stoner Wohlfarth threshold therefor because the previous switching of the magnetization direction of the thinner layer inhibits the switching of the magnetization of the thicker layer. The change in the direction of magnetic field occurring in the thicker layer due to the magnetization of the thinner layer coupled thereto, because of having been previously switched in direction, acts against the switching of the magnetization of the thicker layer to effectively increase its switching threshold.

The magnitude of the magnetic field in the thicker layer due to the magnetization of the thinner layer (and vice versa) depends on the demagnetization fields in these layers, thus allowing, by selecting the interconnection structure current magnitude and the memory cell geometry to achieve an appropriate demagnetization factor value, the setting of the degree of switching inhibition. That is, the width of the peak in characteristic 30 can effectively be set by the cell design in operating conditions. Once this elevated magnitude threshold value (approximately -70 Oe) for the thicker layer is exceeded by the magnitude of the applied field to force its magnetization direction past 90° from the easy axis, the magnetization of this layer also switches to result in the magnetizations of the two ferromagnetic thin-film layers again be oriented in a common direction (although opposite to the initial direction) to thereby sharply lower the resistance value from the peak value of approximately 37 k$\Omega$ to the relatively lower value of again about 31 k$\Omega$. Further increases in the magnitude of the negative field do not significantly further change the resistance value as the magnetization directions in each layer are forced slightly closer and closer to a common direction. Since the direction of the magnetization of thicker layer 12, 13 can only be switched by fields having magnitudes greater than those that switch the magnetization direction of thinner layer 13', 12', the direction of magnetization of thicker layer 12, 13 effectively determines the binary value, "0" or "1", of the data bits stored in the cell.

Hence, traversing this large portion of characteristic 30 shown in Figure 4 by changing the externally applied magnetic field due to word line current from a relatively large positive magnitude to a relatively large negative magnitude in the presence of a sufficient interconnection structure current is equivalent to changing the magnetic state of both layers from pointing in one direction to pointing in the opposite direction, i.e. to storing a new data bit by changing the previously stored data therein based on the direction of the magnetization from its initial direction and binary value to another direction and value. If the initially stored data bit value was the same as the new value to be stored, the corresponding increase in the externally applied field magnitude in the opposite direction to store this new data bit, i.e.

the increasing of the field in a positive direction rather than in the negative direction as described above, would not cause traversing the peak in characteristic 30 thus leaving the layer magnetization's direction and the data bit value unchanged.

The remaining characteristic, 31, in Figure 4 develops just as did characteristic 30 if started from where the development of characteristic 30 terminated as described above, that is, by applying a positively increasing magnitude field in the presence of a sufficient interconnection structure current based field magnitude after the occurrence of a large magnitude negative field. Again, the peak in the cell resistance arises in this characteristic by first encountering a threshold like and near to a Stoner Wohlfarth threshold for switching thinner ferromagnetic layer 13', 12' (approximately 8 Oe) to increase the cell resistance from again about 31kΩ to around 37 kΩ, and thereafter encountering the elevated magnitude threshold for switching thicker layer 12, 13 (approximately 58 Oe) to decrease the cell resistance back to about 31 kΩ. Thus, storing a data bit of either a "0" or "1" binary value in a memory cell 17 having the characteristics shown in Figure 4, as represented by the orientation direction of the magnetization of thicker layer 12,13 along its easy axis in the scheme just described, requires the application of a sufficient magnitude word line field in the corresponding direction along that axis in the presence of a sufficient magnitude interconnection and support structure field.

Retrieving the stored data without disrupting the value of that data is easily done in a memory cell or bit structure 17 having characteristics 30 and 31, the current one of these characteristics that the cell resistance will follow upon application of interconnection support current and word line current based fields having been determined by the direction of orientation of the last external field applied to the cell sufficiently large to switch the magnetizations of both cell ferromagnetic thin-film layers in the presence of the chosen interconnection and support line current. A limited externally applied field, the limit imposed by limiting the corresponding word line current and possibly the interconnection and support line current in the presence of the interconnection and support line current chosen is initially provided having a value capable of placing the resistance of the cell at one of its peak values in either one or the other of characteristics 30 and 31, and the cell structure voltage measuring circuitry may be concurrently "autozeroed" to thereby measure a zero value in these circumstances.

Such "autozeroing" circuitry and processing need not be used for a single cell because of the relatively large signal change provided thereby, but the use of several such cells in parallel with one another in the circuit to which the voltage measuring circuitry is applied will reduce the output signal of a cell because of the parallel conduction paths to a value sufficiently small so as to require "autozeroing" if the individual cells in that circuit are not electrically isolated from one another such as by use of a switching arrangement or other electrical isolating means. Of course, the ability to dispose with the need to perform an "autozeroing" step and to eliminate the circuitry therefor can significantly increase the information retrieval rate in the memory cell circuit as well as allowing an increase in the density thereof in a monolithic integrated circuit chip. This initial field is limited in magnitude so as to be unable to switch the direction of magnetization of thicker layer 12, 13 in the presence of chosen interconnection and support line current magnitude.

To complete retrieving the stored cell information, the limited externally applied field is then reversed from its initial direction to a find limited value in the opposite direction that is capable of placing the resistance of the cell at its other characteristic resistance peak, but not capable of switching the direction of magnetization of thicker layer 12, 13 in the presence of the chosen interconnection and support line current magnitude. If the cell resistance is actually at a resistance peak initially in following one of characteristics 30 or 31 because of the direction of the last previously applied word line current base field of a. magnitude sufficient to switch magnetizations of both ferromagnetic layers, the resistance after the field reversal will decrease as the magnetization of the thinner layer switches to be oriented in the same direction as the direction of magnetization of the thicker layer. If the cell resistance is instead following the other characteristics so that it exhibits a relatively low resistance initially, the resistance after the field reversal will increase as the magnetization of the thinner layer switched to be oriented in the direction opposite to the direction of the magnetization of the thicker layer.

Thus, the resistance change on the reversal from a field oriented in one direction of a magnitude limited to be at a resistance characteristic peak to a limited field oriented in the opposite direction will indicate which of the characteristics 30 and 31 the cell followed, and so in what direction the last sufficiently large externally applied magnetic field was oriented to thereby indicate the binary value of the data bit represented thereby. The change in the resistance value, $\Delta R$, is equal to the full change in resistance between the peak resistance value, representing the ferromagnetic layers magnetizations being opposed in direction to one another, to the relatively low resistance value representing the layer magnetizations being oriented in the same direction as one another. This retrieval process provides a bipolar output indication since an increase of this magnitude indicates one stored data bit value and a decrease indicates the opposite stored data bit value. Thus, the difference between the magnetic state indication representing by an increase in resistance, $+\Delta R$, and the magnetic state indication represented by a decrease in resistance, $-\Delta R$, is $+\Delta R-(-\Delta R) = 2\Delta R$. or twice the resistance change value to give the voltage measuring circuitry across the cell structure a readily detectable state differentiating output signal to measure from its "auto-zeroed" initial measuring point.

The rapidity at which such a binary data retrieval operation can be performed in such a memory cell or bit structure 17 is initially limited by the rise time of the currents in interconnection and support 11' and in word line 22, and by the time required to rotate the magnetization vectors in the ferromagnetic layers in response to such a current. However, such a minimum data retrieval time limit on the duration required to retrieve the data can be further lengthened by the response time of the memory cell or bit structure 17 due to the capacitive nature of that cell in having a pair of ferromagnetic conductors on either side of a dielectric layer yielding an effective capacitance. An important parameter for memory cell or bit structure 17 is the intrinsic resistance-capacitance time constant of the device due to that barrier layer 14 resulting therein from the fabrication process of the cell The cell capacitance, C, can be approximately determined for the cell from

$$C = 8.85 \cdot 10^{-18} \cdot 8 \cdot 10^{-6} A / s$$

where A is the area in square microns and s is the thickness of the aluminum oxide portion of barrier layer 14 in microns and a dielectric constant of 8 has been taken as the value appropriate for the aluminum oxide of barrier layer 14. As indicated above, for relatively low voltages across the cell (100 mV or less), the effective resistance through the cell, R, will typically be on the order of $10^4$ to $10^9$ $\Omega$. The resistance of this portion of the barrier layer can be approximated by

$$R = k_1 s e^{k_2 s}$$

where $k_1$ and $k_2$ are constants characterizing the barrier layer material and s again is the thickness of that layer in microns. As a result, the resistance-capacitance time constant which is the product of R and C will then be exponentially dependent on the thickness s of the aluminum oxide portion of barrier layer 14. This time constant product can be reduced by reducing the thickness of the aluminum oxide portion of barrier layer 14 until $k_2 s$ is much smaller than 1, or, as a practical matter, until difficulties in the fabrication process of thin barrier layers prevent further reductions in the thickness thereof.

Figure 5A shows a pair of n-channel enhancement mode MOSFET's, 100 and 101, each having its source electrically connected to aground reference potential terminal, 102, provided in conjunction with a positive voltage power supply terminal, 103, suited for connection to a source of positive voltage. Each of transistors 100 and 101 has its drain connected to the source of a corresponding one of a pair of n-channel enhancement mode MOSFET's, 104 and 105, serving as loads in the drain circuits of the corresponding ones of transistors 100 and 101. Load transistors 104 and 105 each has its gate connected to its drain. These drains in turn are connected to positive supply voltage terminal 103.

The side of the circuit of Figure 5A having transistors 100 and 104 connected in series with one another, and the side of that circuit having transistors 101 and 105 connected in series with one another, are cross-coupled to one another through use of two memory cells or bit structures 17. Each of cells 17 has one side thereof connected to a corresponding one of the drains of transistors 100 and 101, and has the other side thereof connected to the gate of the opposite one of those transistors. In addition, a word line 22 extends past each of cells 17 but carries the current therethrough in opposite directions by each of those cells so as to be able to switch the magnetization directions in the ferromagnetic layers of each cell in a direction opposite to that of the other. A further word line, 22', is also provided past of each of cells 17 so that cells 17 can be selected for magnetization direction changes of the thicker ferromagnetic layer therein through the use of coincident currents in word lines 22 and 22'.

Since of each cells 17 are in the opposite storage state in having the magnetizations of the thicker layers therein pointing in opposite directions with respect to fields generated by currents in word line 22', a switching of voltage from the ground potential to a substantial positive level on positive voltage supply terminal 103 coincident with current through word line 22' will result in one of Cells 17 being in the minimum resistance condition and the other in the maximum resistance condition. As a result, a greater current will pass through the cell with the smaller resistance into the parasitic capacitance extending to ground from the gate of the corresponding one of transistors 100 and 101 to which it is connected. This parasitic gate capacitance will thus gain charge more rapidly to thereby switch that transistor to the "on" condition, and so prevent the opposite one of those transistors from switching into that condition because of the decrease in the drain voltage of the "on" transistor to a value below the threshold voltage of the opposite transistor having its gate connected to this drain as this "on" transistor draws current through its load. The two different voltage levels at the drains of transistors 100 and 101 after such a switching of sufficient positive voltage onto terminal 103 represent the digital information and its complement stored in the thicker ferromagnetic layers of the cells 17.

The flip-flop will maintain this condition for the positive voltage on terminal 103 being maintained even after current is removed from word line 22' since the voltage at the drain of that one of transistors 100 and 101 which is switched into the "on" condition will continue to be of a value less than the threshold voltage of the other. This output result of switching from ground potential to a sufficient positive voltage on terminal 103 along with the coincidental provision of current in word line 22' can be changed for the next such switching only by having previously coincidentally provided word line currents through word line 22' and word line 22 to thereby have switched the magnetizations of the thicker one of the ferromagnetic layers in each of cells 17.

A similar operation is achieved in the complementary metal-oxide-semiconductor field-effect transistor (CMOS) circuit of Figure 5B when the voltage on positive supply voltage terminal 103 is increased from ground potential to a sufficient positive potential, but the dependence on the parasitic capacitance of the gates of transistors 100 and 101 is not as significant because of the changed configuration. Transistors 104 and 105 in Figure 11A are replaced with a pair of p-channel enhancement mode transistors, 104' and 105', in Figure 11B with the gates thereof electrically connected to the corresponding gates of transistors 100 and 101, respectively. The gates of transistors 100 and 104' are cross-coupled to the other side of the circuit through being directly connected to the drain of transistor 105', and the gates of transistors 101 and 105' are similarly cross-coupled by being directly connected to the drain of transistor 104'. Cells 17 are each connected between the source of one of transistors 104' and 105' and the drain of the corresponding one of transistors 100 and 101.

Thus, as positive voltage is switched onto positive supply terminal 103 with a coincident current flowing in word line 22', the one of cells 17 having the larger resistance will lead to a greater voltage drop across it and the corresponding one of transistors 100 and 101 to the drain of which it is connected so as to switch into the "on" condition first the opposite one of those transistors. A temporary current will flow through this "on" condition transistor, the cell 17 connected to its drain and the p-channel transistor connected to that cell with this latter transistor than switching into the "off" condition. This will leave the other p-channel transistor in the "on" condition and the n-channel transistor in series therewith and the other cell 17 in the "off" condition. Again, this output result of switching from ground potential to a sufficient positive voltage on terminal 103 along with the coincidental provision of current in word line 22' can be changed for the next such switching only by having previously coincidentally provided word line currents through word line 22' and word line 22 to thereby have switched the magnetizations of the thicker one of the ferromagnetic layers in each of cells 17.

The circuit shown in Figure 5C has the cells 17 repositioned from the drain circuits of transistors 100 and 101, as shown in Figure 11B, to the source circuits of those transistors to each be connected between a corresponding one of those sources and ground. Much the same operation will occur for this circuit as the for the circuit in Figure 11B except that the one of cells 17 having the larger resistance leading to a greater voltage drop across it will prevent the one of transistors 100 and 101 connected thereto from switching into the "on" condition first resulting in the other of those transistors doing so.

**Claims**

1.  A ferromagnetic thin-film based digital memory circuit, said circuit comprising:

    a pair of switching devices (100, 101), each having first and second terminating regions and a control region by which that said switching device is capable of being directed to provide a conductive path between that said switching device first and second terminating regions of a selected conductivity;
    a pair of load devices (104,105,104', 105') each capable of conducting current therethrough to result in a voltage drop thereacross and each electrically connected in series with said second terminating region of a corresponding one of said pair of switching devices (100, 101) and interconnection means (103) suited for electrical connection to a source of electrical energization, said pair of load devices (104, 105, 104', 105') each also being coupled to a control region of that one of said pair of switching devices (100, 101) opposite that with which it is electrically connected in series;
    a pair of bit structures (17,17) each coupled to a corresponding one of said pair of load devices (104,105, 104', 105') or to said second terminating region of a corresponding one of said pair of switching devices (100, 101) and arranged so as to result in different value voltages at said control regions of said pair of switching devices (100,101) for selected increases in voltage magnitude on said interconnection means (103), said bit structures (17) comprising:

    a nonmagnetic intermediate layer (14), said intermediate layer having two major surfaces on opposite sides thereof, and
    a memory film (12, 13, 12', 13') of an anisotropic ferromagnetic material on each of said intermediate layer surfaces having switching thresholds for magnetizations of said film adjacent each of said intermediate layer (14) major surfaces that differ in value for a switching of these magnetizations from both being directed initially at least in part in substantially a common direction to being directed at least in part in substantially opposite directions versus a switching from being directed initially at least in part in substantially opposite directions to both being directed at least in part in substantially a common direction; and

    a pair of word line structures (22, 22') each having a pair of word line end terminal regions adapted to conduct electrical current in at least one direction therethrough, each of said pairs of word line end terminal regions having an electrical conductor electrically connected therebetween which is located across an electrical insulating layer (21) from said memory film (12, 13, 12',13') on one of said major surfaces of said intermediate layer (14) of a corresponding one of said bit structures.

2. The apparatus of claim 1 wherein each of said pair of bit structures (17, 17) is electrically connected between one of said pair of load devices (104, 105) and a said control region of one of said pair of switching devices (100, 101).

3. The apparatus of claim 1 wherein said intermediate layer (14) is of an electrically insulative material.

4. The apparatus of claim 1 wherein each of said pair of bit structures (17, 17) is electrically connected between one of said pair of load devices (104', 105') and a said second terminating region of one of said pair of switching devices (100, 101).

5. The apparatus of claim 1 wherein each of said pair of bit structures (17, 17) is electrically connected to a said first terminating region of one of said pair of switching devices (100, 101).

6. The apparatus of claim 1 wherein a said bit structure (17) has a length along a selected direction and a width substantially perpendicular thereto that is smaller in extent than said length, said memory film (12, 13, 12', 13') in a said bit structure (17) being **characterized by** an anisotropy field, and said width being sufficiently small that demagnetization fields arising in said memory film (12, 13, 12', 13') in response to its saturation magnetization being oriented along that said width exceed in magnitude said anisotropy field.

7. The apparatus of claim 1 wherein a said bit structure (17) has a length along a selected direction and a width substantially perpendicular thereto that is smaller in extent than said length and has a shaped end portion extending over a portion of said length in which said width gradually reduces to zero at an end thereof.

8. The apparatus of claim 1 wherein said memory film (12, 13, 12', 13') at each of said major surfaces of said intermediate layer (14) of at least one of said bit structures (17) is arranged such that there are two separate films (12,13; 12', 13') with one of said separate films on each of said major surfaces, and said intermediate layer (14) is also of an electrical insulating kind of material.

9. The apparatus of claim 8 wherein said bit structure (17) has a length along a selected direction and a width substantially perpendicular thereto that is smaller in extent than said length, said width being less than about two curling lengths of said separate films (12, 13; 12', 13') from edges thereof substantially perpendicular to said width.

10. The apparatus of claim 8 wherein said memory film (12, 13; 12', 13') at each of said major surfaces of said intermediate layer (14) of at least one of said bit structures (17) is a composite film having a thinner stratum of greater magnetic saturation induction adjacent said intermediate layer and a thicker stratum of smaller magnetic saturation induction.

**Patentansprüche**

1. Eine auf einem ferromagnetischen Dünnfilm basierende Digitalspeicherschaltung, wobei die Schaltung folgende Merkmale aufweist:

ein Paar von Schaltvorrichtungen (100, 101), die jede eine erste und eine zweite Abschlussregion und eine Steuerregion aufweisen, durch die diese Schaltvorrichtung gerichtet werden kann, um einen leitfähigen Weg zwischen der ersten und der zweiten Abschlussregion dieser Schaltvorrichtung mit einer ausgewählten Leitfähigkeit zu liefern;
ein Paar von Lastvorrichtungen (104, 105, 104', 105'), die jede in der Lage sind, einen Strom hindurch zu leiten, um zu einem Spannungsabfall darüber zu führen, und die jede elektrisch in Reihe mit der zweiten Abschlussregion einer entsprechenden des Paars von Schaltvorrichtungen (100, 101) und einer Verbindungseinrichtung (103) geschaltet sind, die für eine elektrische Verbindung mit einer Quelle einer elektrischen Energieversorgung geeignet ist, wobei das Paar von Lastvorrichtungen (104, 105, 104', 105') jede auch mit einer Steuerregion dieser einen des Paars von Schaltvorrichtungen (100, 101) gekoppelt ist, die sich derjenigen gegenüber befindet, mit der dieselbe elektrisch in Reihe geschaltet ist;
ein Paar von Bitstrukturen (17, 17), die jede mit einer entsprechenden des Paars von Lastvorrichtungen (104, 105, 104', 105') oder mit der zweiten Abschlussregion einer entsprechenden des Paars von Schaltvorrichtungen (100, 101) gekoppelt sind und angeordnet sind, um zu Spannungen unterschiedlichen Werts an den Steuerregionen des Paars von Schaltvorrichtungen (100, 101) für ausgewählte Zunahmen des Spannungsbetrags an der Verbindungseinrichtung (103) zu führen, wobei die Bitstrukturen (17) folgende Merkmale aufweisen:

eine nicht magnetische Zwischenschicht (14), wobei die Zwischenschicht zwei Hauptoberflächen an gegenüberliegenden Seiten derselben aufweist, und

einen Speicherfilm (12, 13, 12', 13') aus einem anisotropen ferromagnetischen Material an jeder der Zwischenschichtoberflächen, der Umschaltschwellen für Magnetisierungen des Films aufweist, der benachbart zu jeder der Hauptoberflächen der Zwischenschicht (14) ist, die sich im Wert für ein Umschalten dieser Magnetisierungen davon, dass beide anfangs zumindest teilweise im Wesentlichen in eine gemeinsame Richtung gerichtet sind, dazu, dass dieselben zumindest teilweise in im Wesentlichen entgegengesetzte Richtungen gerichtet sind, gegenüber einem Umschalten davon, dass dieselben anfangs zumindest teilweise in im Wesentlichen entgegengesetzte Richtungen gerichtet sind, dazu, dass beide zumindest teilweise in im Wesentlichen eine gemeinsame Richtung gerichtet sind, unterscheiden; und

ein Paar von Wortleitungsstrukturen (22, 22'), die jede ein Paar von Wortleitungsendabschlussregionen aufweisen, die angepasst sind, um einen elektrischen Strom in zumindest einer Richtung hindurch zu leiten, wobei jedes der Paare von Wortleitungsendabschlussregionen einen elektrischen Leiter aufweist, der elektrisch dazwischen geschaltet ist, der über eine elektrisch isolierende Schicht (21) von dem Speicherfilm (12, 13, 12', 13') an einer der Hauptoberflächen der Zwischenschicht (14) einer entsprechenden der Bitstrukturen angeordnet ist.

2. Die Vorrichtung gemäß Anspruch 1, bei der jede des Paars von Bitstrukturen (17, 17) elektrisch zwischen eine des Paars von Lastvorrichtungen (104, 105) und eine Steuerregion einer des Paars von Schaltvorrichtungen (100, 101) geschaltet ist.

3. Die Vorrichtung gemäß Anspruch 1, bei der die Zwischenschicht (14) aus einem elektrisch isolierenden Material ist.

4. Die Vorrichtung gemäß Anspruch 1, bei der jede des Paars von Bitstrukturen (17, 17) elektrisch zwischen eine des Paars von Lastvorrichtungen (104', 105') und eine zweite Abschlussregion von einer des Paars von Schaltvorrichtungen (100, 101) geschaltet ist.

5. Die Vorrichtung gemäß Anspruch 1, bei der jede des Paars von Bitstrukturen (17, 17) elektrisch mit einer ersten Abschlussregion von einer des Paars von Schaltvorrichtungen (100, 101) verbunden ist.

6. Die Vorrichtung gemäß Anspruch 1, bei der eine Bitstruktur (17) eine Länge entlang einer ausgewählten Richtung und eine Breite aufweist, die dazu im Wesentlichen senkrecht ist und die in ihrer Erstreckung kleiner als die Länge ist, wobei der Speicherfilm (12, 13, 12', 13') in einer Bitstruktur (17) durch ein Anisotropiefeld **gekennzeichnet** ist, und wobei die Breite ausreichend klein ist, so dass Entmagnetisierungsfelder, die in dem Speicherfilm (12, 13, 12', 13') ansprechend darauf entstehen, dass seine Sättigungsmagnetisierung entlang dieser Breite ausgerichtet ist, in ihrem Betrag das Anisotropiefeld übersteigen.

7. Die Vorrichtung gemäß Anspruch 1, bei der eine Bitstruktur (17) eine Länge entlang einer ausgewählten Richtung und eine Breite aufweist, die dazu im Wesentlichen senkrecht ist und die in ihrer Erstreckung kleiner als die Länge ist und einen geformten Endabschnitt aufweist, der sich über einen Abschnitt der Länge erstreckt, bei dem die Breite sich an einem Ende desselben allmählich auf Null reduziert.

8. Die Vorrichtung gemäß Anspruch 1, bei der der Speicherfilm (12, 13, 12', 13') an jeder der Hauptoberflächen der Zwischenschicht (14) von zumindest einer der Bitstrukturen (17) derart angeordnet ist, dass zwei getrennte Filme (12, 13; 12', 13') vorliegen, wobei sich einer der getrennten Filme an jeder der Hauptoberflächen befindet, und die Zwischenschicht (14) auch aus einer elektrisch isolierenden Art von Material ist.

9. Die Vorrichtung gemäß Anspruch 8, bei der die Bitstruktur (17) eine Länge entlang einer ausgewählten Richtung und eine Breite aufweist, die im Wesentlichen senkrecht dazu ist und die in ihrer Erstreckung kleiner als die Länge ist, wobei die Breite weniger als etwa zwei Kräusellängen der getrennten Filme (12, 13; 12', 13') von Kanten davon ist, die zu der Breite im Wesentlichen senkrecht sind.

10. Die Vorrichtung gemäß Anspruch 8, bei der der Speicherfilm (12, 13; 12', 13') an jeder der Hauptoberflächen der Zwischenschicht (14) von zumindest einer der Bitstrukturen (17) ein zusammengesetzter Film ist, der eine dünnere Schicht von größerer Magnetsättigungsinduktion benachbart zu der Zwischenschicht und eine dickere Schicht von kleinerer Magnetsättigungsinduktion aufweist.

**Revendications**

1. Circuit de mémoire numérique basé sur une couche mince ferromagnétique, ledit circuit comprenant :

  une paire de dispositifs de commutation (100, 101), chacun ayant une première et une seconde régions de terminaison et une région de commande par lesquelles ledit dispositif de commutation est capable d'être dirigé pour fournir un chemin conducteur entre ledit dispositif de commutation et les première et seconde régions de terminaison d'une conductivité sélectionnée ;
  une paire de dispositifs de charge (104, 105, 104', 105'), chacun capable de conduire du courant à travers ces derniers pour résulter dans une chute de tension à travers cela et chacun étant connecté électriquement en série avec ladite seconde région de terminaison de l'un correspondant de ladite paire de dispositifs de commutation (100, 101) et des moyens d'interconnexion (103) adaptés pour une connexion électrique à une source d'excitation électrique, ladite paire de dispositifs de charge (104, 105, 104', 105'), chacun étant également couplé à une région de commande de l'un de ladite paire de dispositifs de commutation (100, 101) opposé à ce avec quoi il est connecté électriquement en série ;
  une paire de structures de bit (17, 17), chacun couplé à l'un correspondant de ladite paire de dispositifs de charge (104, 105, 104', 105') ou à ladite seconde région de terminaison de l'un correspondant de ladite paire de dispositifs de commutation (100, 101) et agencés de façon à résulter dans différentes tensions de valeur auxdites régions de commande de ladite paire de dispositifs de commutation (100, 101) pour des augmentations sélectionnées de l'amplitude de tension sur lesdits moyens d'interconnexion (103), lesdites structures de bit (17) comprenant:

    une couche intermédiaire non magnétique (14), ladite couche intermédiaire ayant deux surfaces principales sur les côtés opposés de cette dernière, et
    un film de mémoire (12, 13, 12', 13') d'un matériau ferromagnétique anisotrope sur chacune desdites surfaces de la couche intermédiaire ayant des seuils de commutation pour les aimantations dudit film adjacent à chacune desdites surfaces principales de la couche intermédiaire (14) qui ont une valeur différente pour une commutation de ces aimantations partant à la fois d'une direction initiale au moins en partie dans une direction essentiellement commune pour être dirigée au moins en partie dans des directions essentiellement opposées par rapport à une commutation partant d'une direction initiale au moins en partie dans des sens essentiellement opposés pour être à la fois dirigée au moins en partie dans une direction essentiellement commune ; et
    une paire de structures de ligne de mot (22, 22'), chacune ayant une paire de régions terminales d'extrémité de ligne de mot adaptées pour conduire du courant électrique dans au moins une direction à travers ceci, chacune desdites paires de régions terminales d'extrémité de ligne de mot ayant un conducteur électrique connecté de façon électrique entre ces dernières qui est situé à travers une couche d'isolation électrique (21) depuis ledit film de mémoire (12, 13, 12', 13') sur l'une desdites surfaces principales de ladite couche intermédiaire (14) de l'une correspondante desdites structures de bit.

2. Appareil selon la revendication 1, dans lequel chacune de ladite paire de structures de bit (17, 17) est connectée électriquement entre l'un de ladite paire de dispositifs de charge (104, 105) et une dite région de commande de l'un de ladite paire de dispositifs de commutation (100, 101).

3. Appareil selon la revendication 1, dans lequel ladite couche intermédiaire (14) est dans un matériau isolé électriquement.

4. Appareil selon la revendication 1, dans lequel chacune de ladite paire de structures de bit (17, 17) est connectée électriquement entre l'un de ladite paire de dispositifs de charge (104', 105') et une dite seconde région de terminaison de l'un de ladite paire de dispositifs de commutation (100, 101).

5. Appareil selon la revendication 1, dans lequel chacune de ladite paire de structures de bit (17, 17) est connectée électriquement à ce que l'on appelle une première région de terminaison de l'un de ladite paire de dispositifs de commutation (100, 101).

**6.** Appareil selon la revendication 1, dans lequel ce que l'on appelle une structure de bit (17) a une longueur le long d'une direction sélectionnée et une largeur essentiellement perpendiculaire à cette dernière qui est plus petite en ampleur que ladite longueur, ledit film de mémoire (12, 13, 12', 13') dans ce que l'on appelle une structure de bit (17) étant **caractérisée par** un champ d'anisotropic, et ladite largeur étant suffisamment petite pour que les champs de désaimantation survenant dans ledit film de mémoire (12, 13, 12', 13') en réponse à son aimantation à saturation étant orientés le long de ladite largeur dépassent en amplitude ledit champ d'anisotropie.

**7.** Appareil selon la revendication 1, dans lequel une dite structure de bit (17) a une longueur le long d'une direction sélectionnée et une largeur essentiellement perpendiculaire à cette dernière qui est plus petite en ampleur que ladite longueur et a une partie d'extrémité profilée s'étendant sur une partie de ladite longueur dans laquelle ladite largeur diminue progressivement jusqu'à zéro à une extrémité de cette dernière.

**8.** Appareil selon la revendication 1, dans lequel ledit film de mémoire (12, 13, 12', 13') à chacune desdites surfaces principales de ladite couche intermédiaire (14) d'au moins l'une desdites structures de bit (17) est agencé de telle sorte qu'il existe deux films séparés (12, 13 ; 12', 13') avec l'un desdits films séparés sur chacune desdites surfaces principales, et ladite couche intermédiaire (14) est également d'un type de matériau à isolation électrique.

**9.** Appareil selon la revendication 8, dans lequel ladite structure de bit (17) a une longueur le long d'une direction sélectionnée et une largeur essentiellement perpendiculaire à cette dernière qui est plus petite en ampleur que ladite longueur, ladite largeur étant inférieure à deux longueurs de bouclage desdits films séparés (12, 13 ; 12', 13') depuis les bords de ces derniers essentiellement perpendiculaires à ladite largeur.

**10.** Appareil selon la revendication 8, dans lequel ledit film de mémoire (12, 13 ; 12', 13') à chacune desdites surfaces principales de ladite couche intermédiaire (14) d'au moins l'une desdites structures de bit (17) est une feuille multicouche ayant une couche plus fine d'induction de saturation magnétique plus grande adjacente à ladite couche intermédiaire et une couche plus épaisse d'induction de saturation magnétique plus petite.

*Fig 1A*

EP 1 316 961 B1

Fig. 1B

Fig. 2

Fig. 3A

EP 1 316 961 B1

Fig. 3B

EP 1 316 961 B1

Fig. 4

EP 1 316 961 B1

Fig. 5A

EP 1 316 961 B1

Fig. 5B

Fig. 5C